# EUROPÄISCHE PATENTSCHRIFT

(11) **EP 1 361 660 B1**
(45) Veröffentlichungstag und Bekanntmachung des Hinweises auf die Patenterteilung: **07.10.2009**
(21) Anmeldenummer: 03008389.3
(22) Anmeldetag: 11.04.2003
(51) Int. Cl.: H03K 17/22

(54) **Elektronische Schaltung mit mindestens einem Eingang zum Wählen eines Zustands der elektonischen Schaltung**
Electronic circuit with at least one input for selecting a state of the electronic circuit
Circuit électronique comportant au moins une entrée pour sélectionner un état du circuit électronique

(30) Priorität: 11.05.2002 DE 10221088
(43) Veröffentlichungstag der Anmeldung: 12.11.2003
(73) Patentinhaber: Braun GmbH, 61476 Kronberg (DE)
(72) Erfinder: Schiebahn, Matthias, 65520 Bad Camberg (DE); Hilscher, Alexander, 61476 Kronberg (DE)

(56) Entgegenhaltungen:
- DE-C- 19 844 481
- US-A- 3 935 476
- US-A- 6 157 051

## Beschreibung

Die Erfindung betrifft eine elektronische Schaltung oder einen elektronischen Schaltkreis, die/der mehrere wählbare Zustände annehmen und dem jeweiligen Zustand entsprechende Funktionen ausführen kann, und mindestens einen Eingang zum Auswählen der Funktionen bzw. Zustände und mindestens einen Ausgang aufweist.

Aus der DE 198 44 481 C1 sind integrierte Schaltungen mit einer Kontaktierungsstelle zum Wählen einer Betriebsart der integrierten Schaltung bekannt. Die Kontaktierungsstelle kann wahlweise mit einem von zwei verschiedenen Versorgungspotentialen der integrierten Schaltung verbunden werden. Die integrierte Schaltung enthält eine Steuereinrichtung, die mit der Kontaktierungsstelle verbunden ist und erkennt, welches der beiden Versorgungspotentiale an der Kontaktierungsstelle anliegt, und die ein entsprechendes Betriebsartsignal erzeugt. Auf diese Weise kann nur zwischen zwei verschiedenen Betriebsarten der integrierten Schaltung gewählt werden.

Soll aber ein elektronischer Schaltkreis mehr als zwei Betriebsarten annehmen können, muß er entweder weitere Eingänge zum Wählen der Betriebsart aufweisen, wie beispielsweise aus der US 6,157,051 bekannt, oder es müssen mehr als zwei Versorgungspotentiale zur Verfügung stehen, die von den Eingängen unterschieden werden können müssen. Besitzt der elektronische Schaltkreis beispielsweise N Eingänge, von denen jeder entweder auf "low"- oder "high"-Potential gelegt sein kann, lassen sich 2^{N} verschiedene Betriebsarten auswählen. Wenn der elektronische Schaltkreis beispielsweise in Form einer anwenderspezifischen integrierten Schaltung in einem Normgehäuse untergebracht ist, ist die benötigte Anzahl von Eingängen aber oft nur durch Wahl eines größeren und teureren Gehäuses mit entsprechend mehr Anschlüssen realisierbar. Die Bereitstellung weiterer Versorgungspotentiale ist ebenfalls aufwendig.

Derartige elektronische Schaltkreise, die je nach ihrer äußeren Beschaltung unterschiedliche Zustände annehmen oder Betriebsarten zulassen, werden vorzugsweise bei Elektrogeräten eingesetzt, von denen es mehrere Gerätevarianten gibt, die sich beispielsweise nur in einigen Leistungs- oder Komfortmerkmalen unterscheiden. Alle Gerätevarianten können dann nämlich mit demselben elektronischen Schaltkreis bestückt werden, insbesondere einer anwenderspezifischen integrierten Schaltung oder einem Mikrokontroller, wobei die einzelnen Komfort- oder Leistungsmerkmale durch die äußere Beschaltung des elektronischen Schaltkreises aktiviert werden können.

Es ist Aufgabe der vorliegenden Erfindung eine elektronische Schaltung anzugeben, die eine Mehrzahl von verschiedenen Zuständen annehmen oder Betriebsarten zulassen kann, die auf einfache Weise über mindestens einen Eingang ausgewählt werden können

Eine erfindungsgemäße elektronische Schaltung besitzt mindestens einen Eingang und mindestens einen Ausgang, durch die ein Zustand der elektronischen Schaltung ausgewählt werden kann. Unter Eingang und Ausgang ist in dieser Anmeldung immer ein Eingang bzw. Ausgang gemeint, der zum Wählen eines Zustands geeignet ist. Besitzt die erfindungsgemäße elektronische Schaltung einen oder mehrere Ausgänge, so gibt sie zumindest in einer Initialisierungsphase an diesen Ausgängen je ein charakteristisches Signal aus, vorzugsweise ein Bitmuster, wobei alle Ausgangssignale voneinander verschieden sind. Besitzt die erfindungsgemäße elektronische Schaltung einen oder mehrere Eingänge, so vergleicht sie zumindest in der Initialisierungsphase die an den Eingängen anliegenden Signale mit den Ausgangssignalen. Besitzt die elektronische Schaltung N Eingänge und M Ausgänge, so lassen sich in diesem Fall M^{N} verschiedene Zustände einstellen. Insbesondere nach der Initialisierungsphase können die Eingänge und Ausgänge zusätzlich auch für andere Zwecke, d.h. in an sich bekannter Weise zur Eingabe bzw. Ausgabe von Signalen aller Art, genutzt werden.

Der gewünschte Zustand einer erfindungsgemäßen elektronischen Schaltung wird somit durch die äußere Beschaltung der elektronischen Schaltung festgelegt, d.h. durch das Vorhandensein oder Fehlen einer Verbindung zwischen mindestens einem Ausgang und mindestens einem Eingang der elektronischen Schaltung. Der gewünschte Zustand wird durch die elektronische Schaltung in Abhängigkeit vom Ergebnis des Vergleichs (der Vergleiche) eingestellt. Auf diese Weise läßt sich leicht eine besonders große Anzahl von unterschiedlichen Zuständen auswählten, wie nachfolgend noch erläutert wird. Unter Initialisierungsphase ist beispielsweise das Inbetriebnehmen der elektronischen Schaltung beim Anlegen der Versorgungsspannung (Power Up) oder das Wiederinbetriebnehmen nach einem Reset zu verstehen, oder allgemeiner der Zeitabschnitt oder die Zeitabschnitte, während dem ein Eingangssignal mit einem charakteristischen Ausgangssignal, ggfs. auch mehrmals nacheinander, verglichen und der gewünschte Zustand eingestellt wird.

Bei einer bevorzugten Ausführung einer erfindungsgemäßen elektronischen Schaltung werden zumindest während der Initialisierungsphase die an den Eingängen anliegenden Signale mit den Versorgungspotentialen der elektronischen Schaltung, insbesondere einem "low"- und/oder einem "high"-Signal und/oder den von den Ausgängen ausgegebenen charakteristischen Signalen verglichen. Besitzt die elektronische Schaltung N Eingänge und M Ausgänge, und stehen L Versorgungspotentiale zur Verfügung, so lassen sich (L+M)^{N} verschiedene Zustände einstellen.

Die elektronische Schaltung enthält eine Steuerschaltung, mit der jeder Eingang der elektronischen Schaltung verbunden ist, und die den gewünschten Zustand bzw. die gewünschten Funktionen der elektronischen Schaltung einstellt. Darunter ist beispielsweise das Setzen von sogenannten Flags zu verstehen, die Verzweigungen in einem in der elektronischen Schaltung gespeicherten Ablaufprogramm steuern, das Aktivieren oder Deaktivieren von Teilen der elektronischen Schaltung beispielsweise durch Ansteuern eines elektronischen Schalters oder dergleichen.

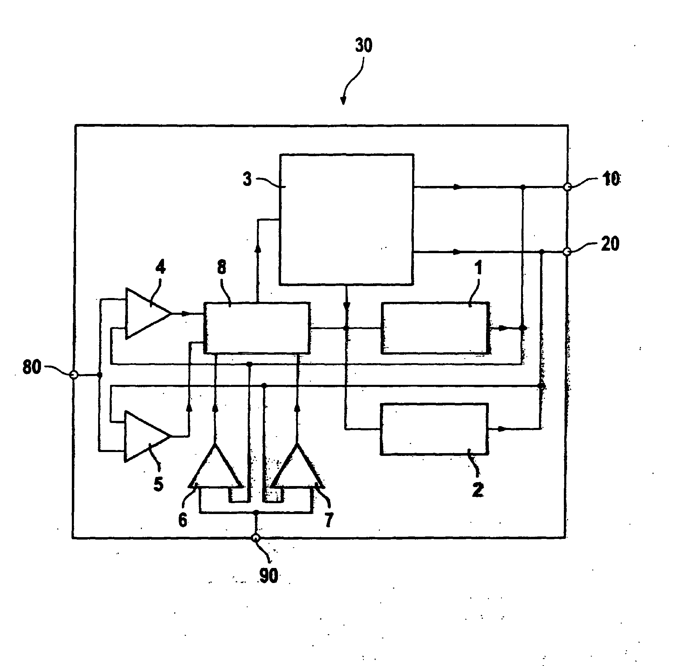

Die Erfindung wird nachstehend anhand eines Ausführungsbeispiels für eine elektronische Schaltung mit zwei Eingängen und zwei Ausgängen erläutert, die schematisch in der einzigen Figur dargestellt ist. Weitere Ausgestaltungen sind in der Beschreibung beschrieben.

Die in der Figur dargestellte elektronische Schaltung 30 enthält einen Schaltkreis 3, der abhängig von seinem jeweiligen Zustand unterschiedliche Funktionen ausführen kann. Die elektronische Schaltung 30 besitzt zwei Ausgänge 10, 20, die mit den Ausgängen des Schaltkreises 3 verbunden sind, und zwei Eingänge 80, 90. Die elektronische Schaltung 30 enthält ferner einen ersten und einen zweiten Speicher 1, 2, in denen zwei voneinander verschiedene Bitmuster gespeichert sind, vier Vergleicher 4, 5, 6, 7 und eine Steuerschaltung 8, die mit den Ausgängen der Vergleicher 4, 5, 6, 7 verbunden ist. Der erste Eingang 80 der elektronischen Schaltung 30 ist mit je einem Eingang der Vergleicher 4, 5 verbunden. Der andere Eingang des Vergleichers 4 ist mit dem Ausgang des ersten Speichers 1 verbunden, und der andere Eingang des Vergleichers 5 ist mit dem Ausgang des zweiten Speichers 2 verbunden. Der andere Eingang 90 der elektronischen Schaltung 30 ist mit je einem Eingang der Vergleicher 6, 7 verbunden. Der andere Eingang des Vergleichers 6 ist mit dem Ausgang des ersten Speichers 1 verbunden, und der andere Eingang des Vergleichers 7 ist mit dem Ausgang des zweiten Speichers 2 verbunden. Der erste und zweite Speicher 1, 2 sowie die Steuerschaltung 8 sind über eine Steuerleitung 9 mit dem Schaltkreis 3 verbunden.

Die Funktionsweise der erfindungsgemäßen elektronischen Schaltung wird nachfolgend kurz beschrieben.

In der Initialisierungsphase der erfindungsgemäßen elektronischen Schaltung 30, d.h. vorzugsweise beim Inbetriebnehmen der elektronischen Schaltung durch Anlegen der Versorgungsspannung (Power Up) oder beim Wiederinbetriebnehmen nach einem Reset, steuert der Schaltkreis 3 über die Steuerleitung 9 den ersten und zweiten Speicher 1, 2 und die Steuerschaltung 8 an, worauf die in den Speichern 1, 2 gespeicherten Bitfolgen ausgelesen und den Ausgängen 10, 20 der elektronischen Schaltung 30 und den Vergleichern 4, 5, 6, 7 zugeführt werden. Die Vergleicher 4, 5, 6, 7 vergleichen die an den Eingängen 80, 90 der elektronischen Schaltung 30 anliegenden Signale mit den Bitfolgen. Die Vergleichsergebnisse hängen davon ab, ob bzw. welcher Eingang 80, 90 mit welchem Ausgang 10, 20 verbunden ist. Die Vergleichsergebnisse werden der Steuerschaltung 8 zugeführt, die daraus ein Steuersignal ableitet, das dem Schaltkreis 3 zugeführt wird und den Zustand der elektronischen Schaltung 30 bestimmt. Somit werden durch die äußere Beschaltung der elektronischen Schaltung 30 die gewünschten Funktionen ausgewählt, die die elektronische Schaltung 30 ausführen soll.

Bei einer anderen Ausführung einer erfindungsgemäßen elektronischen Schaltung enthält die elektronische Schaltung an jedem Eingang mindestens einen zusätzlichen Vergleicher zum Vergleichen der Eingangspegel mit den L Versorgungspotentialen. Die Ausgänge der zusätzlichen Vergleicher sind ebenfalls mit der Steuerschaltung verbunden. Vorzugsweise wird der an einem bestimmten Eingang der elektronischen Schaltung anliegende Eingangspegel mit allen Versorgungspotentialen und allen Bitmustern verglichen, wobei ein bestimmter Ausgang der elektronischen Schaltung auch mit mehreren Eingängen der elektronischen Schaltung verbunden sein kann, um die größtmögliche Anzahl von unterschiedlichen Zuständen auswählen zu können.

## Patentansprüche

1. Elektronische Schaltung oder elektronischer Schaltkreis, die/der mehrere wählbare Zustände annehmen und dem jeweiligen Zustand entsprechende Funktionen ausführen kann, und mindestens einen Eingang zum Wählen eines Zustands und mindestens einen Ausgang aufweist,
**dadurch gekennzeichnet,**
**daß** sie/er einen Vergleicher (4; 5; 6; 7) aufweist, der ein am besagten Eingang (80; 90) anliegende Signal mit einem vom Ausgang (10; 20) ausgegebenen charakteristischen Bitmuster vergleichen kann.

2. Elektronische Schaltung nach Anspruch 1,
**dadurch gekennzeichnet,**
**daß** sie mehrere Ausgänge (10, 20) aufweist, und an jeweils einem bestimmten Ausgang (10, 20) ein charakteristisches Bitmuster ausgeben kann, wobei alle charakteristischen Bitmuster voneinander verschieden sind, und daß sie die an den Eingängen (80, 90) anliegenden Signale mit den von den Ausgängen (10, 20) ausgegebenen Bitmustern vergleichen kann.

3. Elektronische Schaltung nach Anspruch 1 oder 2,
**dadurch gekennzeichnet,**
**daß** der Vergleicher (4; 5; 6; 7) die an den Eingängen (80; 90) anliegenden Signale mit Versorgungspotentialen, insbesondere einem "low"- und einem "high"-Signal, vergleichen kann.

4. Elektronische Schaltung nach einem der vorhergehenden Ansprüche,
**dadurch gekennzeichnet,**
**daß** sie einen von mehreren bestimmten Zuständen annimmt, der vom Ergebnis der Vergleiche des an ihrem Eingang (80; 90) anliegenden Signals bzw. der an ihren Eingängen (80, 90) anliegenden Signale mit dem vom Ausgang (10; 20) ausgegebenen Bitmuster bzw. den von den Ausgängen (10, 20) ausgegebenen Bitmustern und/oder den Versorgungspotentialen abhängt.

5. Elektronische Schaltung nach einem der vorhergehenden Ansprüche,
**dadurch gekennzeichnet,**
**daß** das Ausgeben eines charakteristischen Bitmusters und das Vergleichen des an einem Eingang anliegenden Signals und das Einstellen eines bestimmten Zustands der elektronischen Schaltung während einer Initialisierungsphase stattfindet.

6. Elektronische Schaltung nach Anspruch 5,
**dadurch gekennzeichnet,**
**daß** die Eingänge (80; 90) und/oder Ausgänge (10; 20) zur Einstellung der Zustände der elektronischen Schaltung (30) nach der Initialisierungsphase zur Eingabe bzw. Ausgabe anderer Signale als der zur Einstellung der Zustände der elektronischen Schaltung (30) verwendeten charakteristischen Signale nutzbar sind.

7. Elektronische Schaltung nach einem der vorhergehenden Ansprüche,
**dadurch gekennzeichnet,**
**daß** sie eine Steuerschaltung (8) enthält, die den Zustand der Schaltung (30) einstellen kann.

## Claims

1. An electronic circuit or electronic circuitry, which is able to assume several selectable states and perform functions corresponding to the respective state and has at least one input for selecting a state and has at least one output,
**characterized in that**
it has a comparator (4; 5; 6; 7) which is able to compare a signal applied at said input (80; 90) with a characteristic bit pattern output by the output (10; 20).

2. The electronic circuit according to claim 1,
**characterized in that**
it has several outputs (10, 20) and can output a characteristic bit pattern at a certain output (10, 20), such that all the characteristic bit patterns are different from one another, and it can compare the signals applied to the inputs (80, 90) with the bit patterns output by the outputs (10, 20).

3. The electronic circuit according to claim 1 or 2,
**characterized in that**
the comparator (4; 5; 6; 7) can compare the signals applied to the inputs (80; 90) with power supply potentials, in particular a low signal and a high signal.

4. The electronic circuit according to any one of the preceding claims,
**characterized in that**
it assumes one of several defined states, said state depending on the result of the comparisons of the signal applied at its input (80; 90) and/or the signals applied at its inputs (80, 90) with the bit pattern output by the output (10; 20) and/or with the bit patterns output by the outputs (10, 20) and/or with the power supply potentials.

5. The electronic circuit according to any one of the preceding claims,
**characterized in that**
the output of a characteristic bit pattern and the comparison of the signal applied at an input and the setting of a certain state of the electronic circuit occur during an initialization phase.

6. The electronic circuit according to claim 5,
**characterized in that**
the inputs (80; 90) and/or outputs (10; 20) for setting the states of the electronic circuit (30) after the initialization phase may be used for input and/or output of signals other than the characteristic signals used for setting the states of the electronic circuit (30).

7. The electronic circuit according to any one of the preceding claims,
**characterized in that**
it contains a control circuit (8), which is able to set the state of the circuit (30).

## Revendications

1. Branchement électronique ou circuit électronique qui peut prendre plusieurs états au choix et qui peut exécuter des fonctions correspondant à l'état respectif, et qui présente au moins une entrée pour sélectionner un état et au moins une sortie,
**caractérisé en ce**
**qu'**il présente un comparateur (4, 5, 6, 7) qui peut comparer un signal appliqué à ladite entrée (80, 90) avec un modèle binaire caractéristique délivré par la sortie (10, 20).

2. Circuit électronique selon la revendication 1,
**caractérisé en ce**
**qu'**il présente plusieurs sorties (10, 20) et peut délivrer un modèle binaire caractéristique à chaque fois sur une sortie (10, 20) donnée, tous les modèles binaires caractéristiques étant différents les uns des autres, et qu'il peut comparer les signaux appliqués aux entrées (80, 90) avec les modèles binaires délivrés par les sorties (10, 20).

3. Circuit électronique selon la revendication 1 ou 2,
**caractérisé en ce**
**que** le comparateur (4, 5, 6, 7) peut comparer les signaux appliqués aux entrées (80, 90) avec des potentiels d'alimentation, notamment un signal « bas » et un signal « haut ».

4. Circuit électronique selon l'une des revendications précédentes,
**caractérisé en ce**
**qu'**il prend un état parmi plusieurs états donnés, lequel dépend du résultat de la comparaison du signal appliqué à son entrée (80, 90) ou des signaux appliqués à ses entrées (80, 90) avec le modèle binaire délivré par la sortie (10, 20) ou les modèles binaires délivrés par les sorties (10, 20) et/ou des potentiels d'alimentation.

5. Circuit électronique selon l'une des revendications précédentes,
**caractérisé en ce**
**que** la délivrance d'un modèle binaire caractéristique et la comparaison avec le signal appliqué à une entrée ainsi que l'établissement d'un état donné du circuit électronique ont lieu pendant une phase d'initialisation.

6. Circuit électronique selon la revendication 5,
**caractérisé en ce**
les entrées (80, 90) et/ou les sorties (10, 20) peuvent être utilisées pour établir les états du circuit électronique (30) après la phase d'initialisation en vue de la entrée ou de la sortie d'autres signaux que les signaux caractéristiques utilisés pour établir les états du circuit électronique (30).

7. Circuit électronique selon l'une des revendications précédentes,
**caractérisé en ce**
**qu'**il contient un circuit de commande (8) qui peut établir l'état du circuit (30).
